# EUROPEAN PATENT APPLICATION

(11) **EP 3 007 342 A1**
(43) Date of publication of application: **13.04.2016**
(21) Application number: 15186376.8
(22) Date of filing: 23.09.2015
(51) Int. Cl.: H02M 3/145, H05K 1/14

(54) **INSERTABLE POWER UNIT WITH MOUNTING CONTACTS FOR PLUGGING INTO A MOTHER BOARD**

(30) Priority: 09.10.2014 US 201462061967 P; 17.09.2015 US 201514857430
(71) Applicant: International Rectifier Corporation, El Segundo, CA 90245 (US)
(72) Inventor: Cho, Eung San, Torrance, CA 90505 (US); Ribarich, Thomas J., Laguna Beach, CA 92651 (US); Fernando, Dean, Torrance, CA 90501 (US); Moody, Kevin, Riverside, CA 92503 (US); Park, Dae Keun, Irvine, CA California 92603 (US); Cheah, Chuan, Torrance, CA 90505 (US)
(74) Representative: Dr. Weitzel & Partner

(57) **Abstract**

In one implementation, an insertable power unit for plugging into a mother board includes a power module situated on a substrate, and a mounting contact on an extended side of the substrate away from the power module. The mounting contact is electrically coupled to the power module by electrical routing in the substrate. The mounting contact is configured to provide electrical connection between the power module and the mother board.

## Description

### BACKGROUND

The present application claims the benefit of and priority to a provisional application entitled "Module Card Structures," Serial No. 62/061,967 filed on October 9, 2014. The disclosure in this provisional application is hereby incorporated fully by reference into the present application.

### I. DEFINITION

As used herein, "III-Nitride" or "III-N" refers to a compound semiconductor that includes nitrogen and at least one group III element such as aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), aluminum indium gallium arsenide phosphide nitride (AlₓIn_{y}Ga_{(-x-y)}AsₐP_{b}N_{(1-a-b)}), for example. III-N also refers generally to any polarity including but not limited to Ga-polar, N-polar, semi-polar, or non-polar crystal orientations. A III-N material may also include either the Wurtzitic, Zincblende, or mixed polytypes, and may include single-crystal, monocrystalline, polycrystalline, or amorphous structures. Gallium nitride or GaN, as used herein, refers to a III-N compound semiconductor wherein the group III element or elements include some or a substantial amount of gallium, but may also include other group III elements in addition to gallium. A III-N or a GaN transistor may also refer to a composite high-voltage enhancement mode transistor that is formed by connecting the III-N or the GaN transistor in cascode with a lower voltage group IV transistor.

In addition, as used herein, the phrase "group IV" refers to a semiconductor that includes at least one group IV element such as silicon (Si), germanium (Ge), and carbon (C), and may also include compound semiconductors such as silicon germanium (SiGe) and silicon carbide (SiC), for example. Group IV also refers to semiconductor materials which include more than one layer of group IV elements, or doping of group IV elements to produce strained group IV materials, and may also include group IV based composite substrates such as silicon on insulator (SOI), separation by implantation of oxygen (SIMOX) process substrates, and silicon on sapphire (SOS), for example.

### BACKGROUND ART

Voltage converters are used in a variety of electronic circuits and systems. Many integrated circuit (IC) applications, for instance, require conversion of a direct current (DC) input to a lower, or higher, DC output. For example, a buck converter may be implemented to convert a higher voltage DC input to a lower voltage DC output for use in low voltage applications in which relatively large output currents are required.

The output of a voltage converter is typically provided by a power stage including a high side control transistor and a low side synchronous (sync) transistor, and may utilize relatively large passive devices, such as an output inductor and output capacitor. In addition, voltage converter circuitry typically includes a driver IC designed to drive the control and sync transistors of the power stage. Consequently, packaging solutions for mounting a voltage converter on a mother board typically require mother board surface area sufficient to accommodate a side-by-side layout including not only the control and sync transistors of the voltage converter power stage, but the output inductor, the output capacitor, and the driver IC for the power stage as well.

### SUMMARY

The present disclosure is directed to an insertable power unit with mounting contacts for plugging into a mother board, substantially as shown in and/or described in connection with at least one of the figures, and as set forth in the claims.

### BRIEF DESCRIPTION OF THE DRAWINGS

Figure 1 shows a diagram of an insertable power unit, according to one exemplary implementation.
Figure 2A shows a top view of an insertable power unit with mounting contacts for plugging into a mother board, according to one exemplary implementation.
Figure 2B shows a top view of an insertable power unit with mounting contacts for plugging into a mother board, according to another exemplary implementation.
Figure 3A shows a cross-sectional view of the exemplary insertable power unit shown in Figure 2A.
Figure 3B shows a cross-sectional view of the exemplary insertable power unit shown in Figure 2A prior to being plugged into a mother board.
Figure 3C shows a cross-sectional view of the exemplary insertable power unit shown in Figure 2A plugged into the mother board shown in Figure 3B.
Figure 4 shows a cross-sectional view of yet another exemplary implementation of an insertable power unit with mounting contacts for plugging into a mother board.

### DETAILED DESCRIPTION

The following description contains specific information pertaining to implementations in the present disclosure. One skilled in the art will recognize that the present disclosure may be implemented in a manner different from that specifically discussed herein. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

As stated above, voltage converters are used in a variety of electronic circuits and systems. For instance, and as noted above, integrated circuit (IC) applications may require conversion of a direct current (DC) input to a lower, or higher, DC output. As a specific example, a buck converter may be implemented to convert a higher voltage DC input to a lower voltage DC output for use in low voltage applications in which relatively large output currents are required.

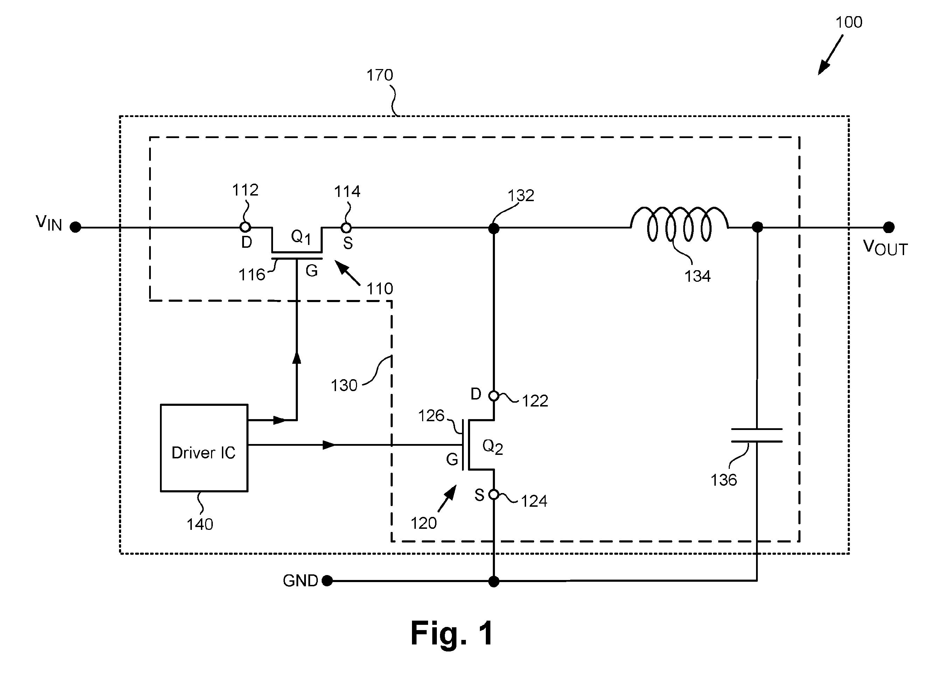

Figure 1 shows a diagram of an insertable power unit including a voltage converter, according to one exemplary implementation. Insertable power unit 100 includes power module 170 containing a voltage converter provided by power stage 130 and driver IC 140 for driving power stage 130. According to the exemplary implementation shown in Figure 1, power stage 130 includes control transistor 110 (Q₁), synchronous (sync) transistor 120 (Q₂), output inductor 134, and output capacitor 136. As shown in Figure 1, power module 170 of insertable power unit 100 is configured to receive an input voltage V_{IN}, and to provide a converted voltage, e.g., a rectified and/or stepped down voltage, as V_{OUT}.

Power stage 130 may be implemented using two power transistors in the form of metal-oxide-semiconductor field-effect transistors (MOSFETs) configured as a half bridge, for example. That is to say, power stage 130 may include high side or control transistor 110 having drain 112, source 114, and gate 116, as well as low side or sync transistor 120 having drain 122, source 124, and gate 126. Control transistor 110 is coupled with sync transistor 120 at switch node 132, which, in turn, is coupled to output inductor 134. Respective control and sync transistors 110 and 120 may be implemented as group IV based power transistors, such as silicon power MOSFETs having a vertical design, for example. Power module 170 may be advantageously utilized as a voltage converter, for example a buck converter, in a variety of automotive, industrial, appliance, and lighting applications.

It is noted that in the interests of ease and conciseness of description, the present inventive principles will in some instances be described by reference to specific implementations of a buck converter including one or more silicon based power FETs. However, it is emphasized that such implementations are merely exemplary, and the inventive principles disclosed herein are broadly applicable to a wide range of applications, including buck and boost converters, implemented using other group IV material based, or group III-V semiconductor based, power transistors. By way of example, control transistor 110 and sync transistor 120 may be implemented as III-Nitride power transistors in the form of heterostructure FETs (HFETs) such as gallium nitride (GaN) or other III-Nitride high electron mobility transistors (HEMTs).

As shown in Figure 1, the voltage converter packaged by insertable power unit 100 utilizes power stage 130 including control transistor 110, sync transistor 120, output inductor 134, and output capacitor 136 to provide output voltage V_{OUT}. In addition, the voltage converter packaged by insertable power unit 100 includes driver IC 140. As a result, conventional packaging solutions for mounting such a voltage converter on a mother board would typically require mother board surface area sufficient to accommodate a side-by-side layout including not only control transistor 110 and sync transistor 120, but output inductor 134, output capacitor 136, and driver IC 140 as well.

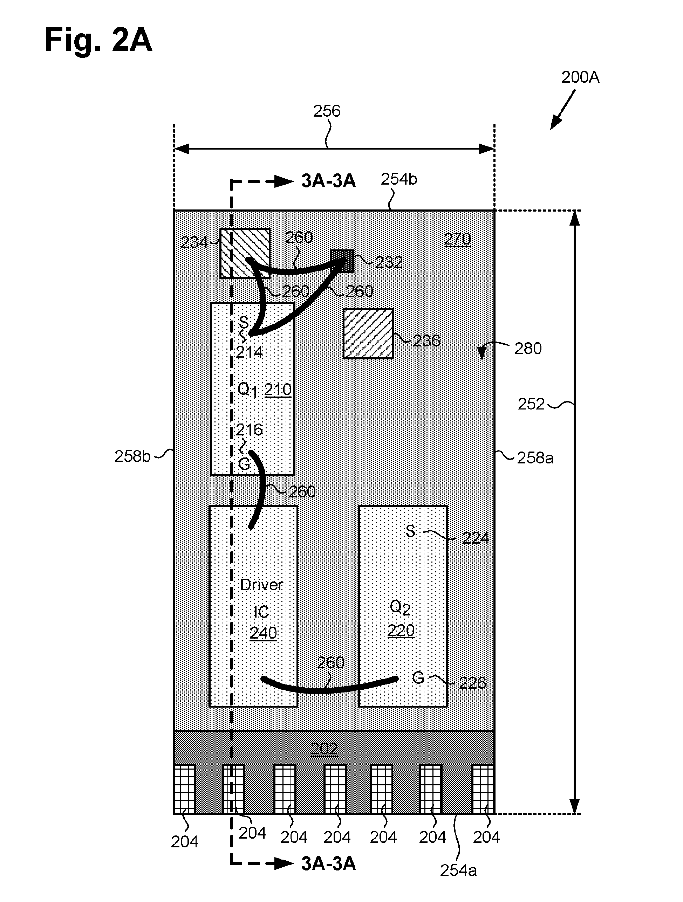

The present application discloses a packaging solution in the form of an insertable power unit with mounting contacts for plugging into a mother board, that provides a highly compact design for packaging power stage 130, alone, or in combination with driver IC 140, as power module 170. As discussed below, insertable power unit 100 may be configured for edge-mounting on a mother board, thereby substantially reducing the mother board surface area required to implement the voltage converter. Alternatively, and as further discussed below, insertable power unit 100 may be configured for end-mounting on the mother board, thereby advantageously further reducing use of mother board surface area. Figure 2A shows an exemplary representation of such a packaging solution.

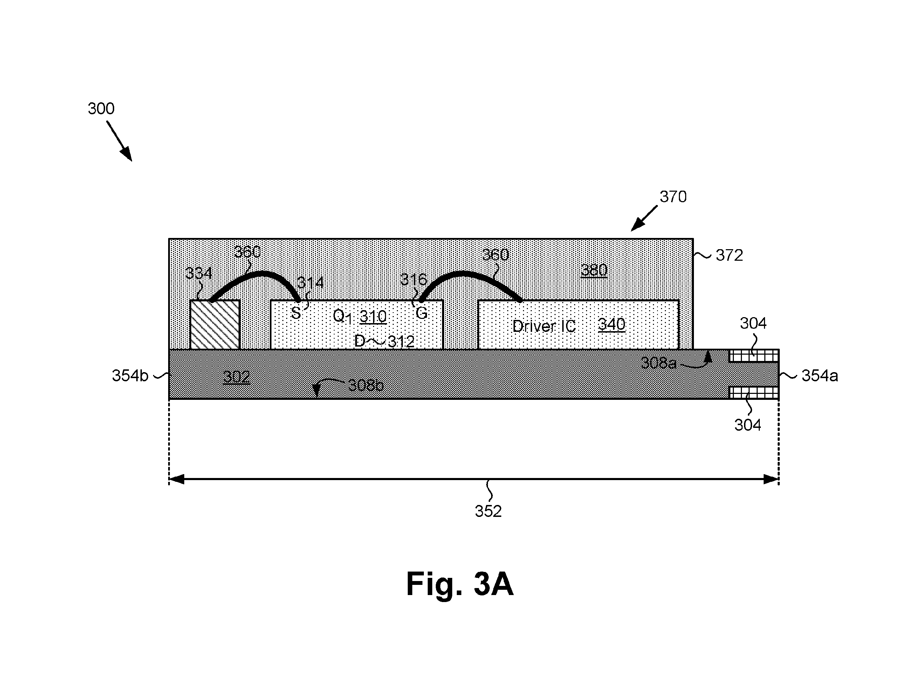

Figure 2A shows a top view of insertable power unit 200A, according to one exemplary implementation. Insertable power unit 200A includes power module 270 situated on substrate 202. According to the exemplary implementation shown in Figure 2A, power module 270 includes control transistor 210 (Q₁), sync transistor 220 (Q₂), switch node 232, output inductor 234, output capacitor 236, driver IC 240, electrical connectors 260, and encapsulant material 280. Also shown in Figure 2A are perspective lines 3A-3A corresponding to the cross-sectional view of insertable power unit 200A shown by Figure 3A and discussed below.

It is noted that encapsulant material 280 may be any suitable electrically insulating material used as overmolding or encapsulation in semiconductor packaging. It is further noted that although, in practice, encapsulant material 280 is formed over and covers control transistor 210, sync transistor 220, switch node 232, output inductor 234, output capacitor 236, driver IC 240, and electrical connectors 280, Figure 2A depicts those features as though "seen through" encapsulant material 280 for the purposes of conceptual clarity.

As shown in Figure 2A, insertable power unit 200A has length 252 determined by first and second ends 254a and 254b of insertable power unit 200A, as well as width 256 determined by first and second edges 258a and 258b of insertable power unit 200A. For the purposes of the present application, length 252 of insertable power unit 200A is greater than width 256 of insertable power unit 200A.

In addition to power module 270 and substrate 202, insertable power unit 200A includes mounting contacts 204 on an extended side of substrate 202 away from power module 270 and providing first end 254a of insertable power unit 200A. Mounting contacts 204 are electrically coupled to power module 270 by electrical routing within substrate 202. Mounting contacts 204 are configured to provide electrical connections between power module 270 and a mother board into which insertable power unit 200A is plugged (mother board not shown in Figure 2A). Thus, insertable power unit 200A is configured for end-mounting on the mother board.

Insertable power unit 200A including power module 270 corresponds in general to insertable power unit 100 including power module 170, in Figure 1, and may share any of the characteristics attributed to that corresponding feature in the present application. Control transistor 210, sync transistor 220, switch node 232, output inductor 234, and output capacitor 236, in Figure 2A correspond respectively in general to control transistor 110, sync transistor 120, switch node 132, output inductor 134, and output capacitor 136, in Figure 1, and may share any of the characteristics attributed to those corresponding features in the present application.

Control transistor 210, in Figure 2A, is shown to include top side source 214 and top side gate 216 corresponding respectively to source 114 and gate 116 of control transistor 110, in Figure 1, while sync transistor 220 is shown to include top side source 224 and top side gate 226 corresponding respectively to source 124 and gate 126 of sync transistor 120. Although not visible in the perspective shown in Figure 2A, it is to be understood that, according to the present exemplary implementation, control transistor 210 is implemented as a vertical power FET having a bottom side drain opposite top side source 214 and top side gate 216 and corresponding to drain 112 of control transistor 110, in Figure 1. Moreover, exemplary sync transistor 220 is also implemented as a vertical power FET having a bottom side drain opposite top side source 224 and top side gate 226 and corresponding to drain 122 of sync transistor 120, in Figure 1.

According to the exemplary implementation shown in Figure 2A, power module 270 includes driver IC 240, as well as all of the features included in power stage 130 of Figure 1. However, in some implementations, it may be advantageous or desirable to omit driver IC 240 from power module 270. In those implementations, insertable power unit 200A may be configured to package control transistor 210, sync transistor 220, and one or both of output inductor 234 and output capacitor 236, but to omit driver IC 240.

Mounting contacts 204 may be implemented using any suitable electrically conductive material or materials, and are collectively configured to provide power module 270 with electrical connections to ground, V_{IN}, and V_{OUT}, shown in Figure 1. For example, in some implementations, substrate 202 may comprise a printed circuit board (PCB) configured as a daughter board. In those implementations, mounting contacts 204 can be electrically coupled to power module 270 by routing traces within the PCB of substrate 202.

With respect to electrical connections among the features contained by power module 270, it is noted that the bottom side drain of sync transistor 220 corresponding to drain 122, in Figure 1, may be electrically connected to top side source 214 of control transistor 210 at switch node 232 by electrical routing within substrate 202, as well as by electrical connectors 260. It is further noted that although electrical connectors 260 are depicted as wire bond in Figure 2A, that representation is merely for the purposes of conceptual clarity.

More generally, electrical connectors 260 may be implemented as conductive clips, ribbons, strips, or vias, such as through-substrate vias, or as conductive traces on a PCB. In other words, control transistor 210 may be coupled to sync transistor 220 by an electronic connector selected from the group consisting of a clip, a ribbon, a strip, a through-substrate via, a trace of a PCB, and a wire bond. In addition, driver IC 240 may be coupled to one or both of control transistor 210 and sync transistor 220 by an electrical connector selected from the group consisting of a clip, a ribbon, a strip, a through-substrate via, a trace of a PCB, and a wire bond.

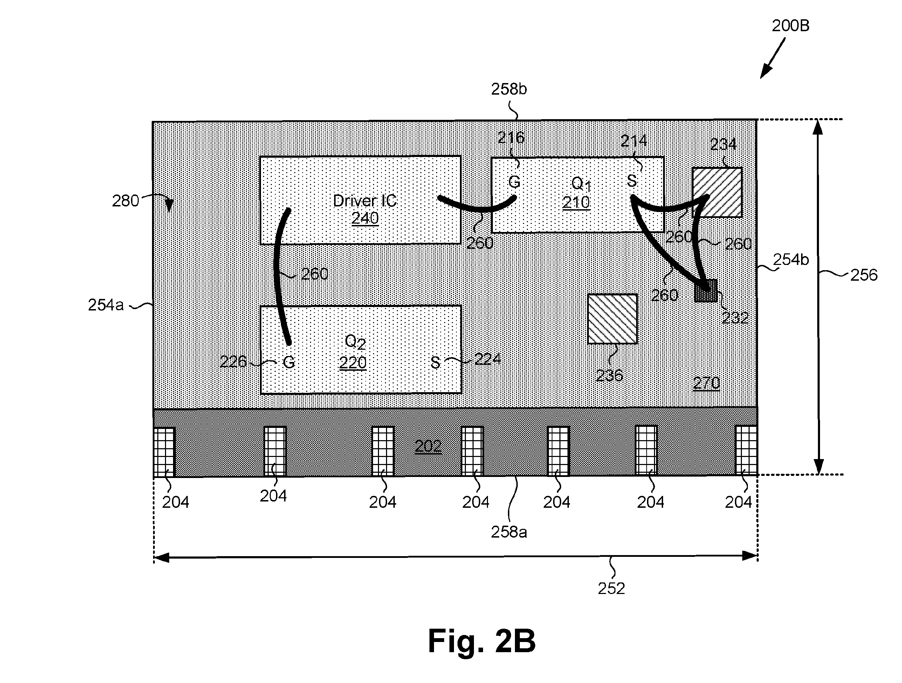

Moving to Figure 2B, Figure 2B shows a top view of insertable power unit 200B with mounting contacts 204 for plugging into a mother board, according to another exemplary implementation. It is noted that all features in Figure 2B identified by reference numbers shown in and described by reference to Figure 2A, above, correspond respectively to those features and may share any of the characteristics attributed to those corresponding features in the present application.

In contrast to insertable power unit 200A, in Figure 2A, however, mounting contacts 204 of insertable power unit 200B are situated on an extended side of substrate 202 away from power module 270 and providing first edge 258a of insertable power unit 200B. As described previously by reference to Figure 2A, mounting contacts 204 are electrically coupled to power module 270 by electrical routing within substrate 202. Mounting contacts 204 are configured to provide electrical connections between power module 270 and a mother board into which insertable power unit 200B is plugged (mother board not shown in Figure 2B). Thus, insertable power unit 200B is configured for edge-mounting on the mother board.

Referring to Figure 3A, Figure 3A shows a cross-sectional view of exemplary insertable power unit 200A, in Figure 2A, according to one implementation, along perspective lines 3A-3A in Figure 2A. Insertable power unit 300 has length 352 determined by first and second ends 354a and 354b of insertable power unit 300, and includes power module 370 situated on front surface 308a of substrate 302. As shown in Figure 3A, power module 370 includes control transistor 310, driver IC 340 for driving control transistor 310, and output inductor 334, all situated on front surface 308a of substrate 302. As further shown in Figure 3A, power module 370 includes electrical connectors 360 and encapsulation material 380, and has exterior wall 372 situated adjacent mounting contacts 304 of insertable power unit 300. Also shown in Figure 3A are drain 312, source 314, and gate 316 of control transistor 310, as well as back surface 308b of substrate 302 opposite front surface 308a.

Insertable power unit 300 having length 352 determined by first and second ends 354a and 354b corresponds in general to insertable power unit 200A having length 252, determined by first and second ends 254a and 254b, in Figure 2A, and may share any of the characteristics attributed to that corresponding feature in the present application. That is to say, power module 370, substrate 302, and mounting contacts 304 correspond respectively in general to power module 270, substrate 202, and mounting contacts 204, in Figure 2A, and may share any of the characteristics attributed to those corresponding features in the present application. Thus, mounting contacts 304 formed on front surface 308a and back surface 308b of substrate 302 are electrically coupled to power module 370 by electrical routing in substrate 302, which may be implemented as a PCB configured as a daughter board.

It is noted that although not visible from the perspective shown by Figure 3A, due to being obscured by control transistor 310, driver IC 340, and encapsulation material 380, power module 370 of insertable power unit 300 also includes a sync transistor and output capacitor corresponding respectively to sync transistor 220 and output capacitor 236, in Figure 2A. Moreover, according to the exemplary implementation shown by Figures 2A and 3A, control transistor 210/310 and sync transistor 220 are situated on the same surface of substrate 202/302, i.e., front surface 308a. In addition to the features previously attributed to insertable power unit 100/200A/200B/300, it is noted that exterior wall 372 of power module 370 adjacent mounting contacts 304 may be substantially perpendicular to front surface 308a of substrate 302.

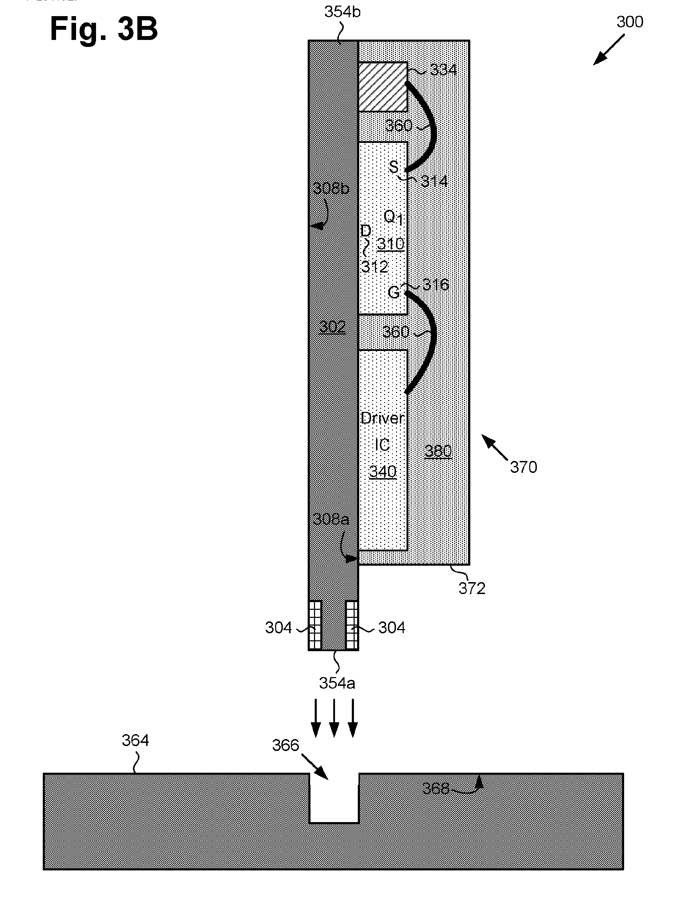

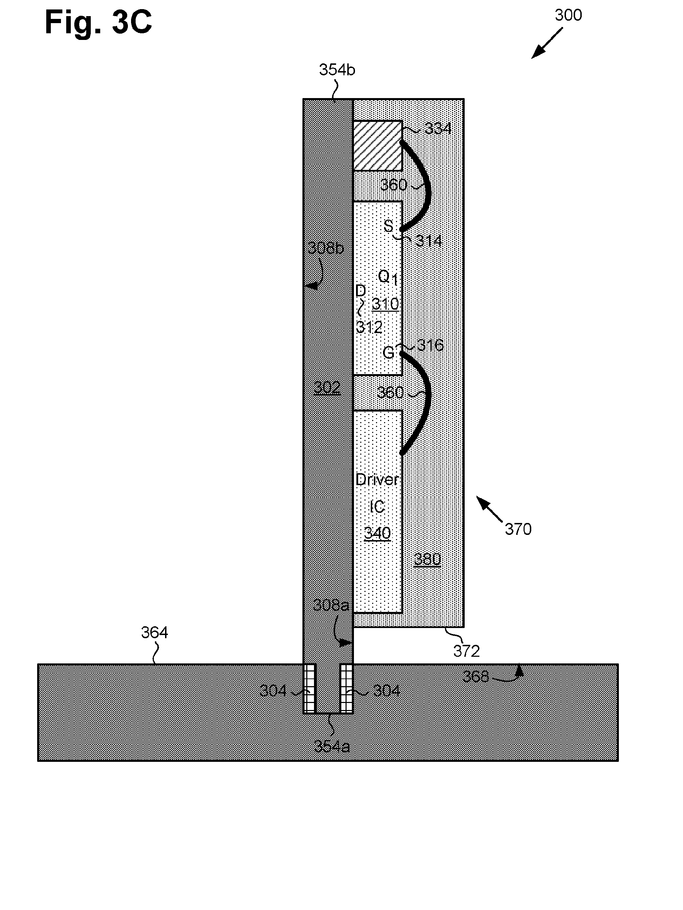

Continuing to Figures 3B and 3C, Figure 3B shows a cross-sectional view of exemplary insertable power unit 300 prior to being plugged into a mother board, while Figure 3C shows insertable power unit 300 plugged into the mother board. It is noted that all features in Figures 3B and 3C identified by reference numbers shown in and described by reference to Figure 3A, above, correspond respectively to those features and may share any of the characteristics attributed to those corresponding features in the present application.

In addition to insertable power unit 300, Figure 3B shows mother board 364 having major surface 368 including slot 366, while Figure 3C shows first end 354a of insertable power unit 300 plugged into slot 366 so as to be end-mounted on mother board 364. Consequently, mounting contacts 304 are placed into contact with electrical routing contained within mother board 364, which may be implemented as a PCB, so as to provide electrical connection between power module 370 and mother board 364.

Thus, according to the implementation shown by Figures 3B and 3C, substrate 302, which may also be implemented using a PCB, may be configured as a daughter board of mother board 364, and may be advantageously configured for end-mounting on mother board 364. According to the implementation shown in Figures 3B and 3C, end-mounting of insertable power unit 300 on mother board 364 results in front surface 308a and back surface 308b of substrate 302 being substantially perpendicular to major surface 368 of mother board 364.

It is noted that insertable power unit 200B, in Figure 2B, may be analogously configured for edge-mounting on mother board 364. In that implementation, however, slot 366 would be configured to receive first edge 258a of insertable power unit 200B. It is noted that edge-mounting of insertable power unit 200B on mother board 364 would also result in front surface 308a and back surface 308b of substrate 202/302 being substantially perpendicular to major surface 368 of mother board 364.

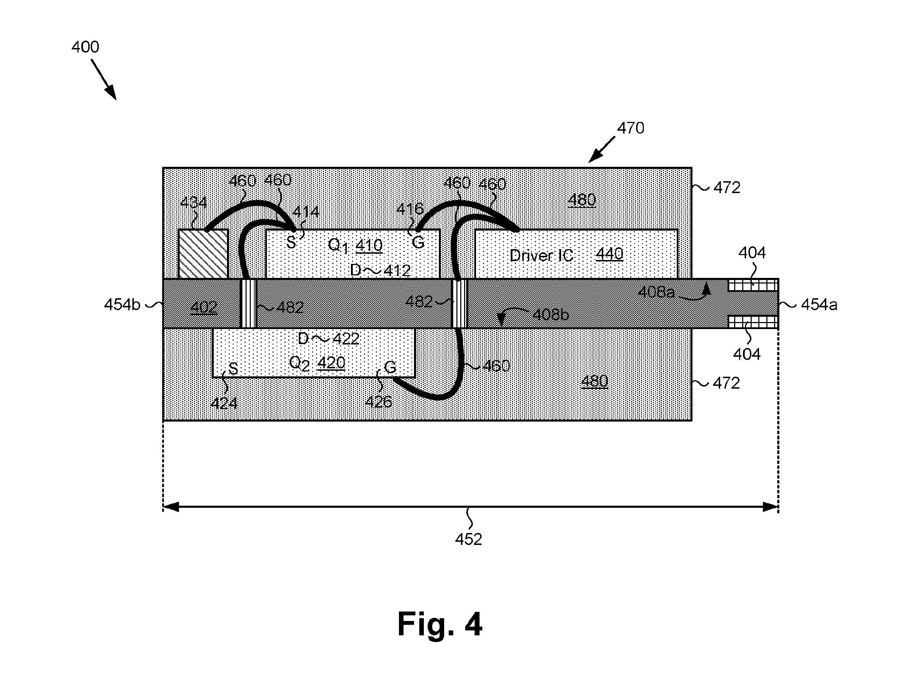

Moving to Figure 4, Figure 4 shows a cross-sectional view of yet another exemplary implementation of an insertable power unit with mounting contacts for plugging into a mother board. Insertable power unit 400 has length 452 determined by first and second ends 454a and 454b of insertable power unit 400, and includes power module 470 situated on substrate 402. As shown in Figure 4, power module 470 includes control transistor 410, driver IC 440 for driving control transistor 410, and output inductor 434, all situated on front surface 408a of substrate 402. In addition, power module 470 includes sync transistor 420 situated on back surface 408b of substrate 402 opposite front surface 408a and electrically coupled to control transistor 410 and driver IC 440 by through-substrate vias 482.

As further shown in Figure 4, power module 470 includes electrical connectors 460 and encapsulation material 480, and has exterior walls 482 situated adjacent mounting contacts 404 of insertable power unit 400. Also shown in Figure 4 are drain 412, source 414, and gate 416 of control transistor 410, as well as drain 422, source, 424, and gate 426 of sync transistor 420.

Length 452 determined by first and second ends 454a and 454b corresponds in general to length 252/352, determined by first and second ends 254a/354a and 254b/354b, in Figure 2A/3A/3B/3C, and may share any of the characteristics attributed to that corresponding feature in the present application. Moreover, substrate 402, mounting contacts 404, electrical connectors 460, and encapsulation material 480 correspond respectively in general to substrate 202/302, and mounting contacts 204/304, electrical connectors 260/360, and encapsulation material 280/380 in Figure 2A/3A/3B/3C, and may share any of the characteristics attributed to those corresponding features in the present application. Thus, mounting contacts 404 formed on front surface 408a and back surface 408b of substrate 402 are electrically coupled to power module 470 by electrical routing in substrate 402, which may be implemented as a PCB configured as a daughter board.

In addition, control transistor 410, sync transistor 420, driver IC 440, and output inductor 434 correspond respectively in general to control transistor 110/210/310, sync transistor 120/220, driver IC 140/240/340, and output inductor 134/234/334, in Figure 1/2A/2B/3A/3B/3C, and may share any of the characteristics attributed to those corresponding features in the present application. It is noted that although not visible from the perspective shown by Figure 4, due to being obscured by control transistor 410, and/or driver IC 440, and/or encapsulation material 480, power module 470 of insertable power unit 400 also includes an output capacitor corresponding respectively to output capacitor 136/236, in Figure 1/2A/2B. It is noted that, according to the exemplary implementation shown in Figure 4, exterior walls 472 of power module 470 adjacent mounting contacts 404 are substantially perpendicular to front surface 408a and back surface 408b of substrate 402.

By analogy to insertable power unit 300, in Figures 3A, 3B, and 3C, insertable power unit 400, in Figure 4, may be advantageously configured for end-mounting on a mother board corresponding to mother board 364, in Figures 3B and 3C. Moreover, according to the implementation shown in Figure 4, end-mounting of insertable power unit 400 at first end 454a would result in front surface 408a and back surface 408b of substrate 402 being substantially perpendicular to a major surface of the mother board corresponding to major surface 368 of mother board 364. Furthermore, and by analogy to insertable power unit 200B, in Figure 2B, it is noted that insertable power unit 400, in Figure 4, may be adapted for edge-mounting on a mother board.

Thus, the present application discloses a packaging solution in the form of an insertable power unit with mounting contacts for plugging into a mother board, that provides a highly compact design for packaging a voltage converter. The insertable power unit disclosed in the present application may be configured for edge-mounting on a mother board, thereby substantially reducing the mother board surface area required to implement the voltage converter. Alternatively, such an insertable power unit may be configured for end-mounting on the mother board, thereby advantageously further reducing use of mother board surface area.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the scope of those concepts. As such, the described implementations are to be considered in all respects as illustrative and not restrictive. It should also be understood that the present application is not limited to the particular implementations described herein, but many rearrangements, modifications, and substitutions are possible without departing from the scope of the present disclosure.

## Claims

1. An insertable power unit for plugging into a mother board, said insertable power unit comprising:
a power module situated on a substrate;
said substrate having a mounting contact on an extended side of said substrate away from said power module;
said mounting contact being electrically coupled to said power module by an electrical routing in said substrate;
said mounting contact configured to provide electrical connection between said power module and said mother board.

2. The insertable power unit of claim 1, wherein said substrate comprises a printed circuit board (PCB) configured as a daughter board.

3. The insertable power unit of claim 1, wherein said extended side of said substrate is on an end of said substrate for end-mounting on said mother board.

4. The insertable power unit of claim 1, wherein said extended side of said substrate is on an edge of said substrate for edge-mounting on said mother board.

5. The insertable power unit of claim 1, wherein said substrate further comprises at least one through-substrate via.

6. An insertable power unit for plugging into a mother board, said insertable power unit comprising:
a power module comprising a control transistor and a sync transistor of a power stage situated on a substrate;
said substrate having a mounting contact on an extended side of said substrate away from said power module;
said mounting contact being electrically coupled to at least one of said control transistor and said sync transistor by an electrical routing in said substrate;
said mounting contact configured to provide electrical connection between said power module and said mother board.

7. The insertable power unit of claim 6, wherein said substrate comprises a printed circuit board (PCB) configured as a daughter board.

8. The insertable power unit of claim 6, wherein said extended side of said substrate is on an end of said substrate for end-mounting on said mother board.

9. The insertable power unit of claim 6, wherein said extended side of said substrate is on an edge of said substrate for edge-mounting on said mother board.

10. The insertable power unit of claim 6, wherein said control transistor is coupled to said sync transistor by an electrical connector selected from the group consisting of a clip, a ribbon, a strip, a through-substrate via, a trace of a printed circuit board, and a wire bond.

11. The insertable power unit of claim 6, wherein said control transistor and said sync transistor are situated on opposite surfaces of said substrate.

12. The insertable power unit of claim 6, wherein said control transistor and said sync transistor are situated on a same surface of said substrate.

13. The insertable power unit of claim 6, wherein said substrate further comprises at least one through-substrate via.

14. The insertable power unit of claim 6, wherein said power module comprises a driver integrated circuit.

15. The insertable power unit of claim 6, wherein at least one of said control transistor and said sync transistor is a III-Nitride transistor.
